# EUROPEAN PATENT SPECIFICATION

(11) **EP 1 153 429 B1**
(45) Date of publication and mention of the grant of the patent: **25.11.2009**
(21) Application number: 99968737.9
(22) Date of filing: 09.09.1999
(51) Int. Cl.: H01L 21/52

(54) **AN ELECTRONIC ARRANGEMENT COMPRISING A COMPONENT CARRIER AND A METHOD OF PRODUCING AN ELECTRONIC ARRANGEMENT**
EINE ELEKTRONISCHE ANORDNUNG, WELCHE EINEN KOMPONENTENTRÄGER BEINHALTET, UND EINE METHODE ZUR HERSTELLUNG EINER ELEKTRONISCHEN ANORDNUNG
STRUCTURE ELECTRONIQUE AVEC SUPPORT POUR COMPOSANTS ELECTRONIQUES ET PROCEDE DE PRODUCTION D'UNE TELLE STRUCTURE

(30) Priority: 09.09.1998 SE 9803043
(43) Date of publication of application: 14.11.2001
(73) Proprietor: TELEFONAKTIEBOLAGET LM ERICSSON (publ), 164 83 Stockholm (SE)
(72) Inventor: BERGSTEDT, Leif, S-518 40 Sjömarken (SE); LIGANDER, Per, S-414 56 Göteborg (SE); BOUSTEDT, Katarina, S-413 28 Göteborg (SE)
(74) Representative: Vejgaard, Christian
(86) International application number: PCT/SE1999/001568
(87) International publication number: WO 2000/014788

(56) References cited:
- GB-A- 2 202 673
- US-A- 4 480 013
- US-A- 5 272 113
- US-A- 5 400 210
- PATENT ABSTRACTS OF JAPAN & JP 04 206 797 A (MITSUBISHI ELECTRIC CORP.) 28 July 1992
- PATENT ABSTRACTS OF JAPAN & JP 63 155 754 A (NEC. CORP.) 28 June 1988

## Description

### TECHNICAL FIELD

The present invention relates to a component carrier for electronic components which offers good retention of the components even in applications which develop great heat.

### STATE OF THE ART

Most electronic constructions comprise electronic components which are mounted on a carrier. The purpose of the carrier is inter alia to provide mechanical support to the component. Common materials used in carriers are, for example, epoxy-glass materials or ceramic materials. FR-4 and G-10 can be mentioned as examples of common materials.

A common way of arranging an electronic component, for example what is known as a naked chip, on a carrier is that the chip is positioned on a surface of the carrier, and soldered or glued to the carrier.

Soldering or gluing are methods which offer good retention of components but suffer from a number of disadvantages. These include the disadvantage that the material in soldered joints or glued joints can be weakened owing to ageing phenomena or repeated temperature variations. It is particularly serious if the joints can be weakened by temperature variations, because relatively much energy is generated over a short time in many applications of electronic components, which leads to great heat being developed. Mobile telephones and computers are examples of applications in which joints are required which withstand the generation of much energy and the attendant great temperature variations.

An alternative to soldering or gluing a component to the surface of a carrier is to glue or solder the component firmly in a cavity in the carrier. Of course, this solution also suffers from the above mentioned disadvantages with regard to weakening of the joints owing to ageing or temperature variations. Documents EP 729 183 A2 and EP 774 888 A2 disclose typical examples of arrangements in which electronic components are arranged in cavities in a carrier and are retained by glue or soldering.

PCT application WO 96/22671 A1 discloses an alternative solution for retaining an electronic component in a cavity in a carrier. The arrangement in this document retains the component in a cavity in the carrier by means of electric conductors which moreover connect points on the component to points on the surface of the carrier. Irrespective of whether the conductors are soldered or glued on the respective surfaces of the component and the carrier, the joints will be affected by problems owing to ageing and temperature sensitivity. Furthermore, the arrangement does not appear to be well-suited to use in applications in which much energy is generated and the attendant temperature variations occur, because the electric conductors which retain the component in the aperture can be damaged or even break owing to thermal expansion in the carrier.

The abstract of the Japanese patent document JP 4206797 discloses another example of the technology disclosed in WO 96/22671 A1, namely a carrier with apertures within which electronic components are arranged. The components are retained within the apertures by means of connecting wires, one end of which wires is joined to a side of the component, and the other end is joined to the surface of the carrier. This arrangement is thus susceptible to all of the earlier mentioned drawbacks associated with e.g. soldered or glued joints.

The abstract of the Japanese patent document JP 63155754 discloses an arrangement with all of the above mentioned drawbacks of joints between connecting wires and components. In addition, the arrangement suffers from an additional drawback in that the component is arranged on the surface of the carrier, thus making the arrangement quite bulky.

### DESCRIPTION OF THE INVENTION

A problem that is solved by means of the invention is therefore that of producing an arrangement with a component carrier for electronic components, preferably naked chips, which demonstrates good retention even in the event of much energy being generated and great temperature variations associated with this.

According to the invention, this problem is solved by an electronic arrangement as claimed in claim 1, comprising a component carrier, where the material of the component carrier is selected so that it has essentially the same thermal expansion coefficient as the component. The component carrier has a first and a second main surface, and a first aperture is arranged in the component carrier. The first aperture has a main direction which extends from the first main surface of the carrier towards the second main surface of the carrier, and an electronic component is arranged in this aperture, using retaining means. The aperture in the carrier extends from the first main surface to the second main surface inclusive, in other words the aperture passes through the carrier. The extent of the aperture in a direction parallel to the main surfaces is the same as and coincides with the extent of the component in this direction.

For the features of the preamble of claim 1 see GB-A 2 202 673.

By virtue of the fact that the material of the carrier is given the same thermal expansion coefficient as the component, the component is held in place solely by the mechanical interaction between the carrier and the component, so that the carrier is used as the retaining means for retaining the component in the aperture. In the event of variations in the mechanical form of the carrier owing to temperature variations, the component will demonstrate corresponding variations, which means that the pressure of the carrier against the component will not reach levels which are harmful to the component, at the same time as the component will be held in place in the aperture.

In order to achieve good function with regard to retention of the component in the aperture, the extent of the aperture should be the same as the extent of the component in question in a direction running between the main surfaces of the component carrier at right angles to the main surfaces, and the component positioned in the carrier so that the extents of the aperture and the carrier in said direction coincide.

According to the invention, the carrier is preferably given an extent in the vertical direction which coincides with the extent of the component in this direction, which means that smooth surfaces are obtained on the carrier even in the region of the opening or openings of the aperture, which facilitates mounting of the resulting arrangement in a larger arrangement. Also, this design makes the arrangement slim, which is naturally an advantage in densely packed electronics systems.

In other words, to sum up, an arrangement with a component in a component carrier is obtained, which arrangement affords good retention of the component irrespective of temperature variations and ageing. The arrangement offers good stability in the lateral direction and, owing to the good contact between the component and the carrier, a good heat-dissipation capacity is also obtained.

The invention also relates to a method of producing the electronic arrangement described above.

### DESCRIPTION OF THE DRAWINGS

The invention will be described in greater detail below by means of examples of embodiments and with reference to the appended drawings, in which:
- Fig. 1: shows a basic cross section from the side of an arrangement according to the invention at one stage of production,
- Fig. 2: shows the arrangement from Fig. 1 in the section I-I,
- Fig. 3: shows a basic cross section from the side of an arrangement according to the invention at a later stage of production,
- Fig. 4: shows a basic cross section from the side of an arrangement according to the invention,
- Fig. 5: shows in cross section the principle of how an arrangement according to the invention can be arranged in a larger arrangement, and

### PREFERRED EMBODIMENTS

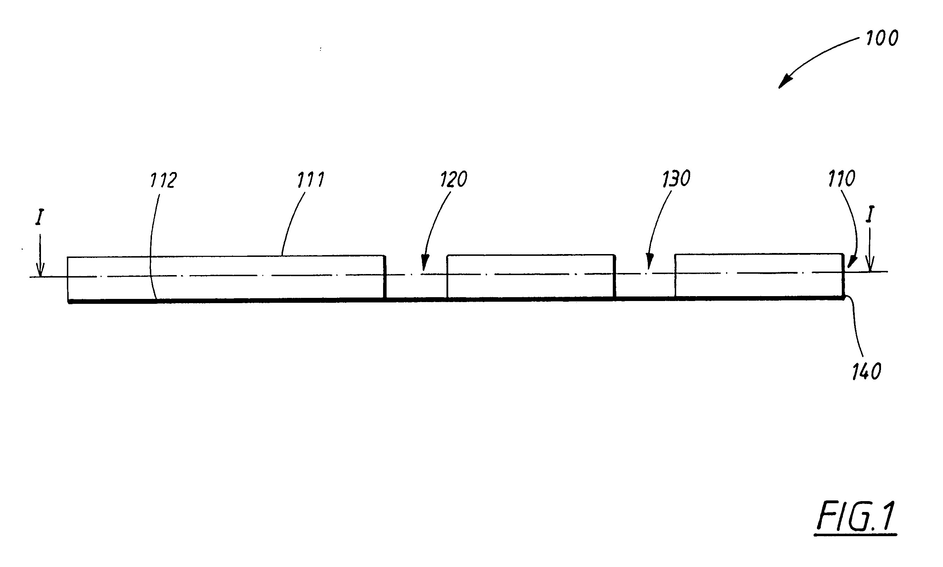

Fig. 1 shows an arrangement 100 according to the invention at a first stage of production. Two cavities or apertures 120, 130 have been arranged in a carrier blank and in this way the desired component carrier 110 is formed. In the example shown, the cavities 120, 130 extend right through the carrier 110, from its first main surface 111 to its second main surface 112. It is also to be understood that the number of cavities shown is only an example.

The cavities 120, 130 in the carrier blank 110 can be formed in a great many different ways which are all well-known to the person skilled in the art and will therefore not be described here. Punching, etching and milling are examples of such methods.

A layer 140 of a relatively rigid mechanical material has been arranged on one main surface 112 of the carrier 110. The purpose of the layer 140 will be described below. In connection with the description of the purpose of the layer 140, it will become clear that the choice of material for the layer 140 is not of decisive importance for it being capable of performing its function. However, plastic film or metal foil are examples of suitable materials.

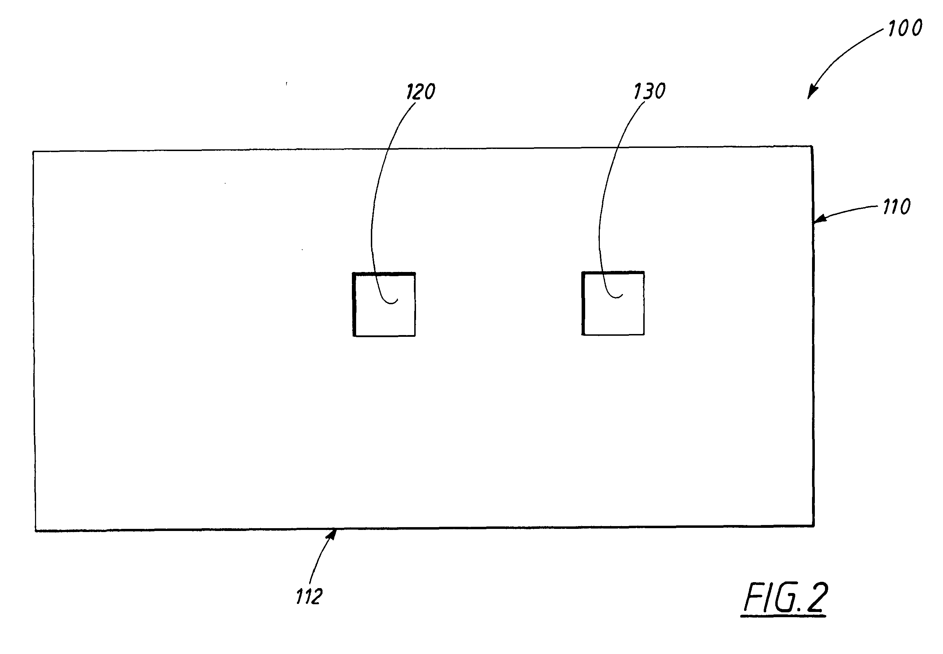

Fig. 2 shows the same arrangement as in Fig. 1, in the section I-I from Fig. 1.

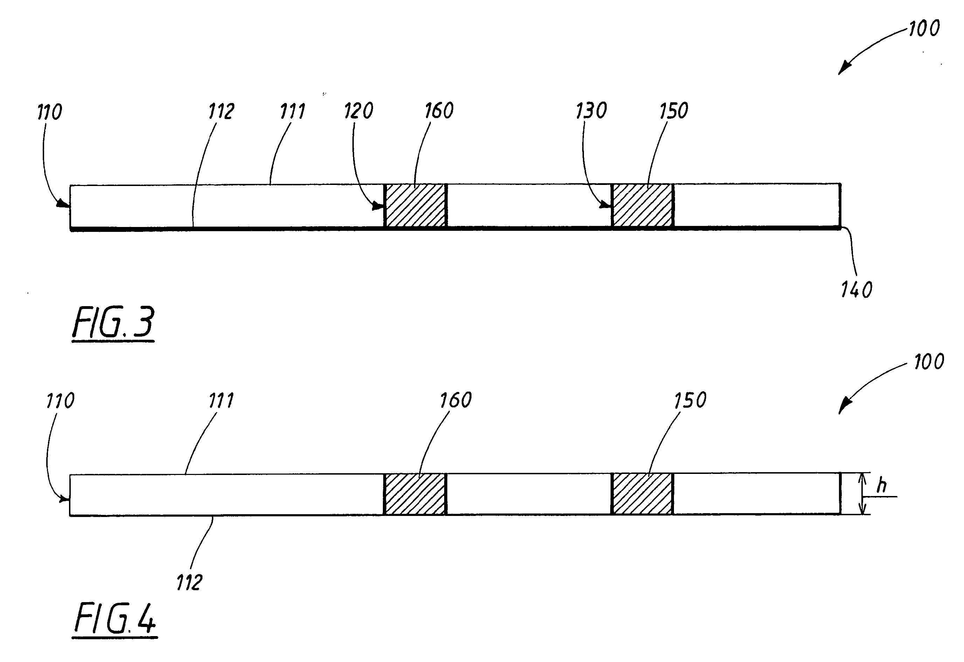

Fig. 3 shows the arrangement 100 according to the invention at a later stage of production. At this stage of production, an electronic component 150, 160 has been positioned in each of the cavities 130, 120. The electronic component is preferably what is known as a naked chip, but other types of component can of course also be used according to the invention. In order to fix the component 150,160 in the aperture or cavity 130,120, retaining means are needed.

According to the invention, the material of the carrier 110 is selected so that it has essentially the same thermal expansion coefficient as the components 150, 160 which are intended to be arranged in the cavities 130, 120 in the carrier. This selection of carrier material means that, in an arrangement according to the invention, the components 150, 160 will be held in place in the carrier by mechanical interaction with the carrier irrespective of temperature variations. For the same reason, in an arrangement according to the invention, pressure on the components from the carrier due to temperature-related expansion will not reach a level which is harmful to the components. Thus, according to the invention, the carrier 110 can serve as the retaining means for retaining the component 150,160 in the aperture 130,120. In fact, according to the invention, the carrier 110 serves as the sole retaining means for the component 150,160.

The material of the carrier can be selected from among a great many materials, but preferably a material is selected from the group usually referred to by the collective name MMC - Metal Matrix Composites. This is a group which includes, for example, materials such as copper-tungsten, CuW, or copper-molybdenum, CuMo. If the material of the carrier is selected from this group, another desirable property of the carrier, namely a good heat-dissipation capacity, is also obtained.

Other groups of materials which are also suitable for use as the carrier material are what are known as metal-ceramic mixtures, which include aluminium silicon carbide, AlSiC, and aluminium silicate, AlSi, and also metal alloys such as, for example, Kovar^{™}.

Fig. 4 shows the arrangement 100 at a subsequent stage of production. At this stage, the layer 140 which had been placed on one main surface 112 of the carrier has been removed. The main purpose of this layer is to hold the component 150, 160 in place while it is being put in position and, if appropriate, during later stages of production. As it is desirable in many applications to have access to the component 150, 160 from both main surfaces, the layer 140 is removed from the arrangement when it has performed its function.

With regard to the dimensions of the carrier, its height h is suitably selected so that it coincides with the corresponding dimension of the component it is to carry. This means that the carrier will in most applications have a height within the range 0.05 - 1.0 millimetres, in a typical case within the range 0.4 - 0.6 millimetres. The width and depth of the carrier are suitably selected according to the application for which the arrangement 100 is intended.

According to the invention, the aperture 120, 130 is given such dimensions in a direction running between the main surfaces of the component carrier, at right angles to the main surfaces, that the extent of the aperture is the same as the extent in this direction of the component for which the aperture is intended. Preferably, the component is then positioned in the aperture in such a manner that the extents of the component and the aperture in said direction coincide. In this fashion, the arrangement is made as slim as possible without exposing the component to the surroundings.
Since the aperture 150,160 extends all the way through the carrier 110, the component can be accessed from two sides, "top" and "bottom", which naturally is an advantage in many applications.

Furthermore, the aperture 120, 130 according to the invention is given an extent in a direction parallel to the main surfaces 112, 113 which is the same as the extent in this direction of the component for which the aperture is intended. When the component is positioned in the aperture, the extent of the component in this direction will coincide with the extent of the aperture in this direction.

The reason for the dimensioning described above of the aperture and the positioning of the component in the aperture is that it is desirable for as much as possible of the surface of the component to come into contact with the carrier because this affords optimum retention of the component in the carrier and optimum utilization of the capacity of the carrier for heat dissipation. At the same time, the component is made accessible from both sides of the carrier, which is also desirable in many applications.

The invention therefore provides on the one hand extremely good retention of a component in a carrier and good heat dissipation and accessibility, and on the other hand an arrangement with smooth surfaces and a small extent in the vertical direction, which is extremely advantageous when the arrangement 100 is to be mounted in a larger arrangement, or if the arrangement 100 is one of a number of arrangements which are to be mounted one on another. Furthermore, consumption of carrier material and the weight and volume of the arrangement are limited by virtue of the carrier not being made "taller" than the component.

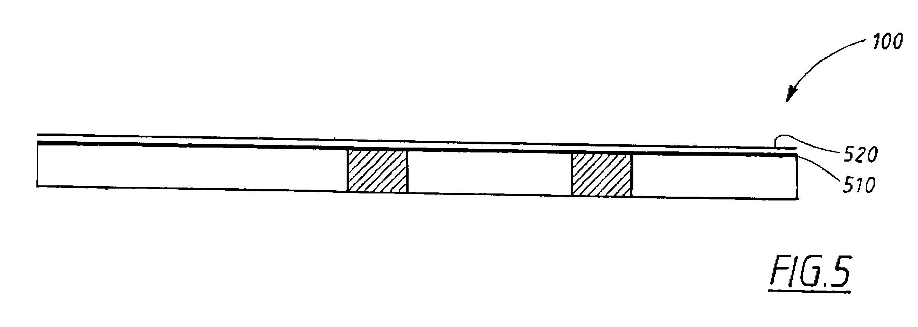

Fig. 5 shows symbolically in a cross section how the arrangement 100 can be used in a larger arrangement. On top of the arrangement 100, a layer 510 of a dielectric material has been arranged, on top of which a circuit pattern 520 has been applied. As the arrangement 100 itself constitutes a mechanically stable carrier, the dielectric layer 510 and the circuit pattern 520 can be made extremely thin, which means that the resulting arrangement is extremely thin, which is of course a great advantage in electronic applications.

## Claims

1. Electronic arrangement (100) comprising a component carrier (110) which has a first (111) and a second (112) main surface, in which component carrier a first aperture (120, 130) is arranged, which first aperture (120, 130) extends from the first main surface (111) to the second main surface (112) inclusive, an electronic component (150, 160) which is arranged in the aperture, and retaining means for retaining the component (150,160) in the aperture (120,130), where the material of the component carrier (110) has essentially the same thermal expansion coefficient as the electronic component (150, 160), and **characterized in that** the carrier (110) serves as the sole retaining means for the component (150,160) by holding the component (150, 160) in place in the aperture (120, 130) by means of mechanical interaction between the carrier (110) and the component (150, 160), where the extent of the aperture (120, 130) in a direction parallel to the main surfaces (111, 112) is the same as and coincides with the extent of the component (150, 160) in this direction.

2. Electronic arrangement (100) according to claim 1, in which the extent of the aperture (120, 130) is the same as the extent of the component (150, 160) in a direction running between the main surfaces (111, 112) of the component carrier at right angles to the main surfaces, and where the component is positioned in the carrier (110) in such a manner that the extents of the component and the aperture in said direction coincide.

3. Method of producing an electronic arrangement (100) comprising a component carrier (110) and a component (150, 160), where the component carrier has a first (111) and a second (112) main surface, according to which method:
- a first aperture (120, 130) is arranged in the component carrier,
- the first aperture (120, 130) is given an extension from the first main surface (111) of the component carrier to the second main surface (112) of the component carrier inclusive,
- an electronic component (150, 160) is arranged in the first aperture (120, 130),
- the electronic component (150,160) is retained within the aperture (120,130) using retaining means,
- a material which has essentially the same thermal expansion coefficient as the electronic component (150, 160) is selected as the material of the component carrier (110),
which method is **characterized in that**
- the component carrier (110) is used as the sole retaining means for the component (150,160) by holding the component (150, 160) in place in the carrier (110) by means of mechanical interaction between the carrier (110) and the component (150, 160), where the aparture (120, 130) is given an extent in a direction parallel to the main surfaces (111, 112), which is the same as and coincides with the extent of the component (150, 160) in this direction.

4. Method according to claim 3, according to which the aperture (120, 130) in the carrier (110) is given an extent which is the same as the extent of the component (150, 160) in a direction running between the main surfaces (111, 112) of the component carrier at right angles to the main surfaces, and according to which method the component is positioned in the carrier in such a manner that the extents of the component and the aperture in said direction coincide.

## Patentansprüche

1. Elektronische Anordnung (100), einen Bauteilträger (110) umfassend, der eine erste (111) und eine zweite (112) Hauptoberfläche hat, wobei im Bauteilträger eine erste Öffnung (120, 130) angeordnet ist, wobei die erste Öffnung (120, 130) von der ersten Hauptoberfläche (111) bis zu einschließlich der zweiten Hauptoberfläche (112) verläuft, ein elektronisches Bauteil (150, 160), das in der Öffnung angeordnet ist, und ein Haltemittel, um das Bauteil (150, 160) in der Öffnung (120, 130) zu halten, wo das Material des Bauteilträgers (110) im Wesentlichen denselben Wärmeausdehnungskoeffizienten wie das elektronische Bauteil (150, 160) hat, und **dadurch gekennzeichnet, dass** der Träger (110) als das einzige Haltemittel für das Bauteil (150, 160) dient, indem er das Bauteil (150, 160) mit Hilfe mechanischer Wechselwirkung zwischen dem Träger (110) und dem Bauteil (150, 160) an seinem Platz in der Öffnung (120, 130) hält, wo das Ausmaß der Öffnung (120, 130) in einer zur Hauptoberfläche (111, 112) parallelen Richtung dieselbe ist wie das Ausmaß des Bauteils (150, 160) in dieser Richtung und mit diesem übereinstimmt.

2. Elektronische Anordnung (100) nach Anspruch 1, in dem das Ausmaß der Öffnung (120, 130) dasselbe ist wie das Ausmaß des Bauteils (150, 160) in einer Richtung, die zwischen den Hauptoberflächen (111, 112) des Bauteilträgers senkrecht zu den Hauptoberflächen verläuft, und wo das Bauteil im Träger (110) so positioniert ist, dass die Ausmaße des Bauteils und der Öffnung in dieser Richtung übereinstimmen.

3. Verfahren zum Herstellen einer elektronischen Anordnung (100), die einen Bauteilträger (110) und ein Bauteil (150, 160) umfasst, wo der Bauteilträger eine erste (111) und eine zweite (112) Hauptoberfläche hat, wobei gemäß dem Verfahren:
- eine erste Öffnung (120, 130) im Bauteilträger angeordnet ist,
- der ersten Öffnung (120, 130) eine Erweiterung von der ersten Hauptoberfläche (111) des Bauteilträgers bis zu einschließlich der zweiten Hauptoberfläche (112) des Bauteilträgers gegeben wird,
- ein elektronisches Bauteil (150, 160) in der ersten Öffnung (120, 130) angeordnet ist,
- das elektronische Bauteil (150, 160) unter Verwendung eines Haltemittels innerhalb der Öffnung (120, 130) gehalten wird,
- ein Material, das im Wesentlichen denselben Wärmeausdehnungskoeffizienten wie das elektronische Bauteil (150, 160) hat, als das Material des Bauteilträgers (110) ausgewählt wird,
wobei das Verfahren **dadurch gekennzeichnet ist, dass**
- der Bauteilträger (110) als das einzige Haltemittel für das Bauteil (150, 160) verwendet wird, indem er das Bauteil (150, 160) mit Hilfe mechanischer Wechselwirkung zwischen dem Träger (110) und dem Bauteil (150, 160) an seinem Platz im Träger (110) hält, wo der Öffnung (120, 130) ein Ausmaß in einer zur Hauptoberfläche (111, 112) parallelen Richtung gegeben wird, das dasselbe ist wie das Ausmaß des Bauteils (150, 160) in dieser Richtung und mit diesem übereinstimmt.

4. Verfahren nach Anspruch 3, gemäß dem der Öffnung (120, 130) im Träger (110) ein Ausmaß gegeben wird, das dasselbe ist wie das Ausmaß des Bauteils (150, 160) in einer Richtung, die zwischen den Hauptoberflächen (111, 112) des Bauteilträgers senkrecht zu den Hauptoberflächen verläuft, und gemäß welchem Verfahren das Bauteil im Träger so positioniert ist, dass die Ausmaße des Bauteils und der Öffnung in dieser Richtung übereinstimmen.

## Revendications

1. Agencement électronique (100) comprenant un support de composant (110) qui comporte une première (111) et une deuxième (112) surface principale, dans lequel support de composant une première ouverture (120, 130) est agencée, laquelle première ouverture (120, 130) s'étend de la première surface principale (111) jusqu'à la deuxième surface principale (112) incluse, un composant électronique (150, 160) qui est agencé dans l'ouverture, et des moyens de retenue pour retenir le composant (150, 160) dans l'ouverture (120, 130), où le matériau du support de composant (110) a essentiellement le même coefficient de dilatation thermique que le composant électronique (150, 160), et **caractérisé en ce que** le support (110) sert en tant que seul moyen de retenue pour le composant (150, 160) en maintenant le composant (150, 160) en place dans l'ouverture (120, 130) au moyen d'une interaction mécanique entre le support (110) et le composant (150, 160), où l'étendue de l'ouverture (120, 130) dans une direction parallèle aux surfaces principales (111, 112) est identique à et coïncide avec l'étendue du composant (150, 160) dans cette direction.

2. Agencement électronique (100) selon la revendication 1, dans lequel l'étendue de l'ouverture (120, 130) est identique à l'étendue du composant (150, 160) dans une direction s'étendant entre les surfaces principales (111, 112) du support de composant à angle droit par rapport aux surfaces principales, et où le composant est positionné dans le support (110) de telle manière que les étendues du composant et de l'ouverture dans ladite direction coïncident.

3. Procédé de production d'un agencement électronique (100) comprenant un support de composant (110) et un composant (150, 160), où le support de composant comporte une première (111) et une deuxième (112) surface principale, selon lequel procédé :
- une première ouverture (120, 130) est agencée dans le support de composant,
- la première ouverture (120, 130) s'étend de la première surface principale (111) du support de composant jusqu'à la deuxième surface principale (112) du support de composant incluse,
- un composant électronique (150, 160) est agencé dans la première ouverture (120, 130),
- le composant électronique (150, 160) est retenu dans l'ouverture (120, 130) en utilisant des moyens de retenue,
- un matériau qui a essentiellement le même coefficient de dilatation thermique que le composant électronique (150, 160) est sélectionné en tant que matériau du support de composant (110),
lequel procédé est **caractérisé en ce que**
- le support de composant (110) est utilisé en tant que seul moyen de retenue pour le composant (150, 160) en maintenant le composant (150, 160) en place dans le support (110) au moyen d'une interaction mécanique entre le support (110) et le composant (150, 160), où l'ouverture (120, 130) a une étendue dans une direction parallèle aux surfaces principales (111, 112) qui est identique à et coïncide avec l'étendue du composant (150, 160) dans cette direction.

4. Procédé selon la revendication 3, selon lequel l'ouverture (120, 130) dans le support (110) a une étendue qui est identique à l'étendue du composant (150, 160) dans une direction s'étendant entre les surfaces principales (111, 112) du support de composant à angle droit par rapport aux surfaces principales, et selon lequel procédé le composant est positionné dans le support d'une manière telle que les étendues du composant et de l'ouverture dans ladite direction coïncident.
